# EUROPÄISCHE PATENTSCHRIFT

(11) **EP 0 838 982 B1**
(45) Veröffentlichungstag und Bekanntmachung des Hinweises auf die Patenterteilung: **06.10.2004**
(21) Anmeldenummer: 97117883.5
(22) Anmeldetag: 15.10.1997
(51) Int. Cl.: H05K 5/02, H01R 13/639

(54) **Abdeckhaube für die Steckerverbindung eines elektronischen Gerätes**
Terminal cover for an electronic apparatus
Capot couvrant le connecteur d'un appareil électronique

(30) Priorität: 24.10.1996 DE 29618524 U
(43) Veröffentlichungstag der Anmeldung: 29.04.1998
(73) Patentinhaber: SIEMENS AKTIENGESELLSCHAFT, 80333 München (DE)
(72) Erfinder: Götz, Franz, 78052 Villingen-Schwenningen (DE)

(56) Entgegenhaltungen:
- DE-A- 3 542 871
- GB-A- 2 278 245
- US-A- 4 861 282
- US-A- 5 286 919

## Beschreibung

Die Erfindung betrifft eine Abdeckhaube für die Steckerverbindung eines elektronischen Gerätes, wobei das Gerät ein flaches, quaderförmiges Gehäuse aufweist und der Steckersockel an der Rückseite des Gehäuses für das Handhaben vorzugsweise mehrerer nebeneinander angeordneter Stecker zugänglich ist.

Bei Geräten mit flachen, quaderförmigen Gehäusen, die insbesondere dem Einbau in Instrumententafeln dienen, sind die Steckerverbindungen zwangsweise der Rückseite des Gerätes zugeordnet, wobei die Höhe des Gerätes die Bauhöhe der Steckerverbindung begrenzt. Das heißt, daß je nach Art der Steckerverbindung, insbesondere wenn mehrere Stecker nebeneinander angeordnet werden, eine in bezug auf das Gehäuse griffgünstige Anordnung der Stecker vorgesehen ist und die Stecker der Handhabung wegen so groß wie möglich gewählt werden, erhebliche räumliche Schwierigkeiten hinsichtlich des Anbringens am Gehäuse und der Gestaltung einer geeigneten, die Stecker sichernden Abdeckung bestehen. Ein Gerät mit einer Abdeckhaube ist aus dem Dokument GB-A-2 278 245 bekannt.

Die Aufgabe der vorliegenden Erfindung bestand somit darin, eine Abdeckung zu schaffen, die unter den gegebenen Bedingungen eine gute Integration mit dem Gehäuse bietet und auf einfache Weise montierbar ist.

Die Lösung dieser Aufgabe geht aus dem Anspruch 1 hervor. Weitere Ausgestaltungen der Erfindung beschreiben die Unteransprüche.

Die gefundene Lösung stellt aufgrund der Bauform ein relativ starres Bauteil dar, welches im montierten Zustand den Steckern als Zugriffssicherung und Leitungsbündelung dient. Die erfindungsgemäße Abdeckhaube wird aber auch der Funktion als Gehäuseteil gerecht, das heißt sie läßt sich als Ergänzung des Gehäuses mit anderen Worten als Abdeckung des Gehäusebereichs verwenden, welcher für die Handhabung der Stecker freigespart ist. Vorteilhaft ist ferner, daß die Abdeckhaube in einer Richtung, das heißt in Richtung der Hochachse des Gerätes montierbar ist, und dabei einerseits formschlüssig mit dem Deckel des Gehäuses deckelbündig verbindbar, andererseits durch geeignete Fügeverbindungen an der Rückwand des Gerätes befestigbar ist. Das heißt, die Abdeckhaube beansprucht in Richtung der Hochachse des Gerätes keinen Raum und fügt sich ästhetisch in die Deckelfläche ein. Erwähnenswert ist außerdem, daß die in der Regel plombierte Abdeckhaube gleichzeitig als Sicherungselement für einen lediglich in einen Rahmen des Gehäuses bajonetartig eingesteckten oder in geeigneter Weise eingeschobenen Deckel dient. Insofern eignet sich die Abdeckhaube auch als Bauelement für Blechgehäuse mit dem Vorzug, daß ein derartiger Deckel nicht verschraubt werden muß.

Die Zeichnungen zeigen ein Ausführungsbeispiel der erfindungsgemäßen Abdeckhaube sowie ein Anwendungsbeispiel der Abdeckhaube in Verbindung mit einem Blechgehäuse. Es zeigen:
- Figur 1: eine Perspektivdarstellung einer Abdeckhaube,
- Figur 2: xeine teilweise Seitenansicht eines Gerätes mit einer Abdeckhaube gemäß Figur 1,
- Figur 3: eine teilweise Draufsicht des Gerätes gemäß Figur 2,
- Figur 4: eine Rückansicht des Gerätes gemäß Figur 2,
- Figur 5: eine vergrößerte Darstellung der Ansicht gemäß Figur 2 mit einem Freischnitt an der Abdeckhaube und einem Teilschnitt des Gehäuses.

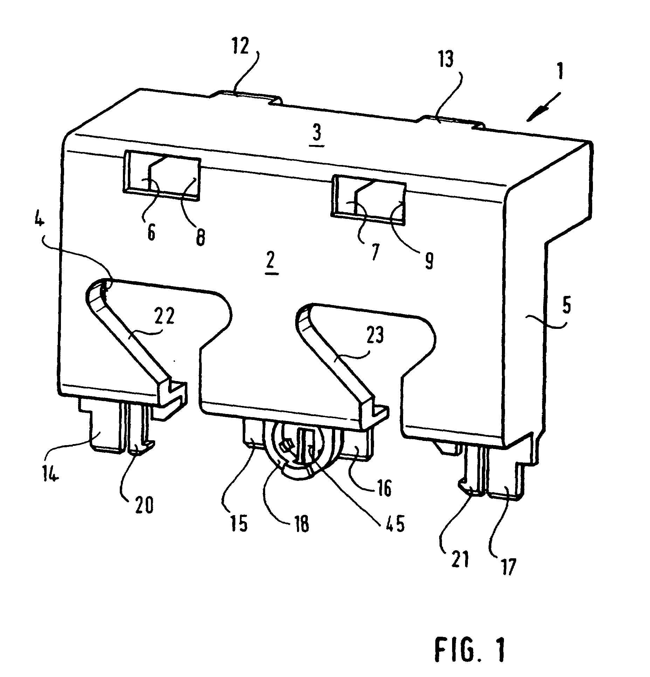

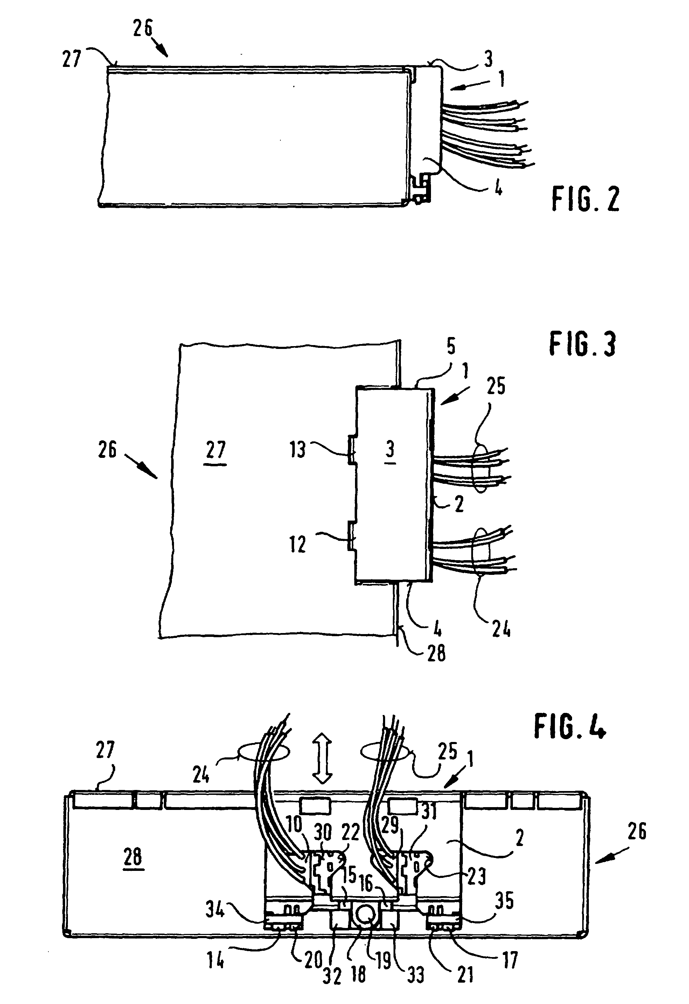

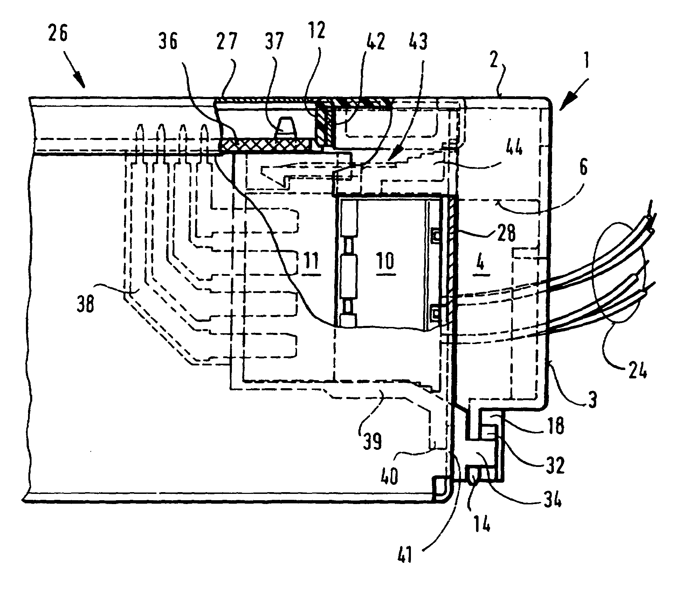

Wie aus der Figur 1 ersichtlich ist, stellt die Abdeckhaube 1 ein Bauteil dar, das ein Winkelprofil aufweist. Dabei sind die im rechten Winkel zueinander stehenden Schenkel 2 und 3 durch Seitenwangen 4 und 5 versteift. Der Versteifung der Abdeckhaube 1 dienen ferner Rippen, von denen in Figur 1 zwei, 6 und 7, durch Öffnungen 8 und 9 im Schenkel 2 sichtbar sind. Bei montierter Abdeckhaube 1 dienen die Rippen 6, 7 außerdem dazu, die Bewegungsfreiheit der Stecker, beispielsweise 10 in Figur 5, in der jeweiligen Fassung im Steckersockel 11 zu begrenzen. Ferner ist aus der Figur 1 ersichtlich, daß in zum Schenkel 2 parallelen Ebenen an der Abdeckhaube 1 Finger 12 und 13 sowie in die gleiche Richtung weisende Zungen 14, 15, 16 und 17 angeformt sind. Mit 18 ist eine Fassung bezeichnet, die für die Aufnahme eines Plombierelementes 19 (Figur 4) vorgesehen ist. Den Zungen 14 und 17 sind in der Zungenebene federnde Riegel 20 und 21 zugeordnet. Im Schenkel 2 ausgebildete pilzförmige Einschnitte 22 und 23 dienen dem Durchführen der durch die Stecker abgeschlossenen Leitungsbündel 24 und 25.

Die Figuren 2, 3 und 4 zeigen die an einem Gehäuse 26 eines elektronischen Gerätes montierte Abdeckhaube 1. Dabei ist ersichtlich, daß der Schenkel 3 der Abdeckhaube 1 mit dem Deckel 27 des Gehäuses 26 flächenbündig ist, wobei, was im folgenden noch näher erläutert wird, die Finger 12 und 13 in den Deckel 27 eingreifen. Die Wangen 4, 5 ragen teilweise in das Gerät hinein, teilweise bilden sie eine gegebenenfalls gefalzte Stoßverbindung mit der in geeigneter Weise für den Zugang zu dem im Gerät befindlichen Steckersockel 11 freigesparten Rückwand 28 des Gehäuses 26. Die Figur 4 zeigt außerdem, daß in dem Steckersockel 11 zwei Stecker 10 und 29 gesteckt sind. Zwei weitere Fassungen 30 und 31 des für vier Stecker ausgelegten Steckersockels 11 sind in dem dargestellten Beispiel unbesetzt. Mit 32 und 33 sind den Zungen 15 und 16 zugeordnete Taschen bezeichnet, die Bezugszeichen 34 und 35 stellen Ösen dar, in welche die Zungen/Riegel-Kombinationen 14/20 und 17/21 eingreifen, wenn die Abdeckhaube 1 an dem Gehäuse 26 angebracht wird.

Wie aus der Figur 5 hervorgeht ist der Steckersockel 11 einer Leiterplatte 36 zugeordnet, und zwar dienen Stifte, von denen einer dargestellt und mit 37 bezeichnet ist, der Lagefixierung und nicht dargestellte Klinken der Befestigung an der Leiterplatte 36. Mit 38 ist eine von mehreren Kontaktschienen bezeichnet, die als Winkelschienen ausgebildet sind und einerseits als Kontaktzungen in die Fassungen der Stecker hineinragen, andererseits in die Leiterplatte 36 eingepreßt und mit auf der Leiterplatte 36 befindlichen Leiterbahnen kontaktiert sind.

Ferner zeigt die Figur 5, daß an dem Steckersockel 11 eine Schürze 39 angeformt ist, die im montierten Zustand der Leiterplatte 36 im Gerät derart aus der Rückwand 28 herausgreift, daß die an der Schürze 39 angeformten Taschen 32, 33 und Ösen 34, 35 für ein rückwandparalleles Einsetzen der Abdeckhaube 1 von außen zugänglich sind. Die Schürze 39 ist durch Anformen von Lappen 40 außerdem derart ausgebildet, daß sie auf einen an der Rückwand 28 unterhalb des für die Handhabung der Stecker 10, 29 erforderlichen, nicht bezeichneten Freisparung bestehenden Steges 41, aufsteckbar ist. Dadurch entsteht zwischen dem Gehäuse 26 und dem auf der Leiterplatte 36 befestigten Steckersockel 11 ein Verbund, der der Versteifung dient. Die Ösen 34, 35 und Taschen 32, 33 können selbstverständlich auch an einem vom Steckersockel unabhängigen, beispielsweise auf den Steg 41 aufpreßbaren Teil ausgebildet oder bei entsprechender Gestaltung unmittelbar aus dem Steg 41 herausgeformt sein.

Wie vorstehend bereits erwähnt, greifen die an der Abdeckhaube 1 ausgebildeten Finger in den Deckel 27 ein. Für diesen Eingriff ist es, wie der Freischnitt der Figur 5 zeigt, bei einer deckelbündigen Lage des Schenkels 3 der Abdeckhaube 1 erforderlich an dem Deckel 27 eine Leiste 42 anzubiegen und im Biegebereich den Fingern 12 und 13 entsprechende Freisparungen vorzusehen. Mit 43 ist ein an dem Gehäuse des Steckers 10 angeformter, für eine Handbetätigung ausgebildeter Riegel bezeichnet. Beim Setzen der Stecker 10, 29 verrasten diese Riegel an einem im Steckersockel 11 ausgebildeten Hinterschnitt. Die Rippen 6, 7 der Abdeckhaube 1 stehen den Betätigungsgliedern 44 der Riegel unmittelbar gegenüber, so daß ein Herausziehen der Stecker 10/29 bei montierter Abdeckhaube 1 nicht möglich ist obwohl für ein knickfreies Herausführen der Leitungen aus der Abdeckhaube 1 zwischen dem Schenkel 2 und den Rückseiten der Stecker ein erheblicher Freiraum besteht.

Der Vollständigkeit halber sei noch erwähnt, daß die Befestigung der Abdeckhaube 1 ausschließlich mittels Zungen/Riegel-Verbindungen erfolgen kann. Soll eine Plombierung der Abdeckhaube 1 erfolgen, so ist es denkbar die Abdeckhaube 1 an dem Steg 41 mittels einer Schraube zu befestigen und den Kopf dieser Schraube mittels einer Plombe zu verschließen. Beim dargestellten Ausführungsbeispiel, bei dem eine Verschraubung nicht erforderlich ist, ist eine Riegelverbindung vorgesehen, die durch den Rand des in die Fassung 18 eingesetzten kappenartigen Plombierelementes 19 gegen Verschieben gesperrt wird. Mit 45 ist ein in der Fassung 18 ausgebildeter Schlitz bezeichnet, über den ein am Steckersockel 11 bzw. an der Schürze 39 ausgebildeter und mit einem Einschnitt versehener Steg in die Fassung 18 eingreift.

## Patentansprüche

1. Elektronisches Gerät mit einer Abdeckhaube für eine Steckerverbindung, wobei das Gerät ein flaches, quaderförmiges Gehäuse aufweist und ein Steckersockel an der Rückseite des Gehäuses für das Handhaben vorzugsweise mehrerer nebeneinander angeordneter Stecker zugänglich ist,
**dadurch gekennzeichent,**
daß die Abdeckhaube (1) als winkelprofiliertes Bauteil ausgebildet ist derart, daß an dessen einem Schenkel (2) Zungen (14, 15, 16, 17) für eine bezüglich des Gehäuses (26) rückwandparallele Fügeverbindung mit einem Gehäuseteil (28) bzw. mit einem gehäusefesten Bauteil (11) des Gerätes und an dessen anderem Schenkel (3) Finger (12, 13) für eine formschlüssige, bezüglich des Gehäuses (26) deckelseitige Halterung an einem Gehäuseteil (27) bzw. an einem gehäusefesten Bauteil (11, 36) des Gerätes angeformt sind.

2. Gerät nach Anspruch 1,
**dadurch gekennzeichnet,**
**daß** die Zungen (14, 15, 16, 17) und die Finger (12, 13) derart angeformt sind, daß sie in ein und dieselbe Richtung weisen.

3. Gerät nach Anspruch 1,
**dadurch gekennzeichnet,**
**daß** den Zungen (14, 17) in der Zungenebene federungsfähige Riegel (20, 21) zugeordnet sind.

4. Gerät nach Anspruch 1,
**dadurch gekennzeichnet,**
**daß** wenigstens einer Zunge (15, 16) eine Fassung (18) für das Einsetzen einer Plombe (19) zugeordnet ist.

5. Gerät nach Anspruch 1,
**dadurch gekennzeichnet,**
**daß** der bezüglich des Gehäuses (26) rückwandseitige Schenkel (2) wenigstens einen der Durchführung von in den Steckern (10, 29) kontaktierten Leitungen (24, 25) dienenden, pilzförmigen Einschnitt (22, 23) aufweist.

## Claims

1. Electronic apparatus with a terminal cover for a plug connection, the apparatus having a flat, cuboidal housing and a plug socket being accessible on the rear side of the housing for the handling of preferably a number of plugs arranged next to one another, **characterized in that** the terminal cover (1) is formed as an angle-profiled component in such a way that formed on its one limb (2) are tongues (14, 15, 16, 17) for a joining connection, parallel to the rear wall with respect to the housing (26), to a housing part (28) or to a component (11) of the apparatus that is fixed to the housing, and formed on its other limb (3) are fingers (12, 13) for a positively engaging securement, on the cover side with respect to the housing (26), to a housing part (27) or to a component (11, 36) of the apparatus that is fixed to the housing.

2. Apparatus according to Claim 1, **characterized in that** the tongues (14, 15, 16, 17) and the fingers (12, 13) are formed on in such a way that they point in one and the same direction.

3. Apparatus according to Claim 1, **characterized in that** the tongues (14, 17) are assigned bolts (20, 21) capable of spring deflection in the plane of the tongues.

4. Apparatus according to Claim 1, **characterized in that** at least one tongue (15, 16) is assigned a receptacle (18) for the insertion of a lead seal (19).

5. Apparatus according to Claim 1, **characterized in that** the limb (2) on the rear wall side with respect to the housing (26) has at least one mushroom-shaped slot (22, 23) serving for leading through leads (24, 25) provided with contacts in the plugs (10, 29).

## Revendications

1. Appareil électronique équipé d'un capot pour le connecteur, l'appareil présentant un boîtier plat de forme parallélépipédique et un socle à connecteurs étant accessible au dos du boîtier pour la manipulation de plusieurs connecteurs juxtaposés de préférence, **caractérisé en ce que** le capot (1) est conçu comme composant en forme de cornière, de sorte que sur l'une de ses ailes (2) des languettes (14, 15, 16, 17) pour une liaison jointive parallèle au panneau arrière par rapport au boîtier (26) avec une partie du boîtier (28) ou avec un composant (11) à boîtier fixe de l'appareil et qu'à son autre aile (3) des doigts (12, 13) pour une fixation par conjugaison de forme par rapport au boîtier (26) côté couvercle sont rapportés par formage sur une partie du boîtier (27) ou sur un composant (11, 36) à boîtier fixe de l'appareil.

2. Appareil selon la revendication 1,
**caractérisé en ce**
**que** les languettes (14, 15, 16, 17) et les doigts (12, 13) sont rapportés par moulage de sorte à être orientés dans une seule et même direction.

3. Appareil selon la revendication 1,
**caractérisé en ce**
**que** des verrous élastiques (20, 21) sont associés aux languettes (14, 17) sur le plan des languettes.

4. Appareil selon la revendication 1,
**caractérisé en ce**
**qu'**une douille (18) pour le montage d'un plomb (19) est associée à au moins l'une des languettes (15, 16).

5. Appareil selon la revendication 1,
**caractérisé en ce**
**que** l'aile (2) du côté du panneau arrière par rapport au boîtier (26) comporte au moins une encoche (22, 23) en forme de champignon servant à faire passer les câbles (24, 25) au contact dans les connecteurs (10, 29).
